# EUROPEAN PATENT SPECIFICATION

(11) **EP 0 356 020 B1**
(45) Date of publication and mention of the grant of the patent: **14.09.1994**
(21) Application number: 89307640.6
(22) Date of filing: 27.07.1989
(51) Int. Cl.: G05F 3/24

(54) **A bias voltage generator for static CMOS circuits**
Vorspannungsgenerator für statische CMOS-Schaltungen
Générateur de tension de polarisation de grille pour des circuits statiques de CMOS

(30) Priority: 15.08.1988 US 232399
(43) Date of publication of application: 28.02.1990
(73) Proprietor: International Business Machines Corporation, Armonk, N.Y. 10504 (US)
(72) Inventor: Correale, Anthony, Jr., Raleigh North Carolina 27613 (US); Luckett, Gary Clair, Cary North Carolina 27511 (US)
(74) Representative: Burt, Roger James, Dr.

(56) References cited:
- US-A- 4 323 846
- US-A- 4 446 383
- US-A- 4 453 121
- US-A- 4 645 998
- US-A- 4 723 108

## Description

This invention relates to a bias voltage generator for static CMOS circuits on a Very Large Scale Integration (VLSI) chip.

Most VLSI chips are now being designed with CMOS technology. It is believed that this trend is an attempt to capitalise on the improved power and performance characteristics which the CMOS technology provides. A typical VLSI chip is made up of thousands of circuit arrangements integrated on a single substrate. Some of these circuits, such as programmable logic arrays (PLA) and busses with several dotted drivers, require static power dissipating circuits in order to ensure proper operation.

One of the disadvantages of these static circuits is that, at worst case, they dissipate a relatively large amount of power. Because CMOS technology is a lower power technology, the presence of static circuits on the CMOS chip negates or undermines one of the benefits associated with the CMOS technology. Even though there are a plurality of different types of static CMOS circuits, an inverter circuit will be used to illustrate the relatively large amount of power which a typical static CMOS circuit dissipates.

US-A-4 723 108 discloses a reference circuit enabling compensation for the natural response of MOS circuits to changes in temperature and manufacturing variances. The circuit comprises a voltage reference circuit biasing a voltage generator circuit controlling gate bias voltage of a load device.

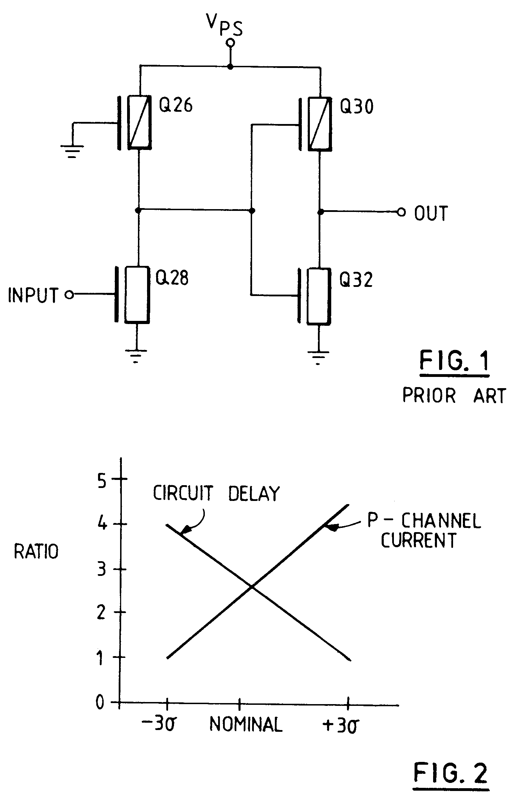

Fig. 1 of the accompanying drawings is a schematic circuit of two typical inverter circuits which include a pair of P-channel devices Q26, Q30, and a pair of N-channel devices Q28, Q32. The source electrodes of the P-channel devices are connected to power supply (Vps) and the source electrodes of the N-channel devices are connected to ground potential. As is the usual practice with static CMOS circuits without availability of depletion NMOS devices, a P-channel FET device (Q26) is used as the load device. To provide the loading function, the gate electrode of Q26 is connected to the ground potential.

Current in the P-channel device can be expressed by the following simplified equation.$\text{I = K (Vgate - Vs - Vt)²,}$
where

K is a function of parameters such as device width, length, gate oxide thickness, etc.

Vgate is the gate voltage of the P-channel device

Vs is the source voltage of the device, the power supply Vps

Vt is the threshold voltage of the device, typically -1 volt

For the P-channel device shown (Vgate - Vs) = Vps

Vps is the power supply voltage typically 5 ± 10%

Variations in the process parameters cause K to vary by as much as +/- 60% between its -3 sigma limit and its +3 sigma limit. Varying the power supply voltage Vps from 4.5 volts to 5.5 volts increases the current in the P-channel device by 50%. Combining process variations and power supply tolerance, the current in the device can vary more than 400% from worst case (-3 sigma limit) to best case (+3 sigma limit) The -3 sigma and +3 sigma limits are statistical terms used to describe standard deviation from a nominal value.

Circuit performance can improve by a factor of 4 between worst case conditions and best case conditions. The designer usually has a worst case performance target for the circuit being designed. The designer then must be able to accommodate the power dissipation of the circuit at best case conditions. If there is a significant number of static circuits on a VLSI chip, the power dissipation at best case conditions will raise the chip's junction temperature, reduce its reliability and decrease the performance of other circuits.

A straightforward approach for solving the power dissipation problem is to package the chip in a ceramic casing. Such a casing usually has lower thermal resistance which keeps the junction temperature lower. Ceramic packages have lower thermal resistance than plastic packages but are more expensive and will make the component less competitive in the market place. In addition, the increased current stresses the current density limits of metal and contact structures further compounding the reliability issues.

The invention seeks to provide an on-chip circuit arrangement which biases static CMOS circuits to reduce the maximum power which is dissipated by the circuits while optimising performance.

According to the present invention there is now provided a bias voltage generator for static circuits on a CMOS chip comprising a first and a second compensation circuit producing a bias reference voltage coupled to at least one load FET to maintain a constant current within the FET or FETs characterised by:
the first compensation circuit comprising a first and second FET device of a first conductivity type which are connected in series between a power supply source and a reference potential and a first FET device of opposite conductivity type which is also connected to the power supply source in series with a pair of first conductivity FET devices which are positioned in parallel with one another and are connected to the drain of said first opposite conductivity type FET device, said first compensation circuit serving to bias a control node at a control voltage whose value is governed by the power supply means and the channel width, length and threshold voltages of the devices;
the control node being coupled to an output means thereby producing a variable bias reference voltage on the gate of said one or more load FETs; and
the second compensation circuit being coupled to the control node and operable to maintain the constant current within the load FET or FETs, via a bias voltage feedback means and comprising a pair of opposite conductivity type FET devices each connected in series with individual first conductivity type FET devices and connected to a further first conductivity type FET device which is connected between the control node and the reference potential and to a first conductivity type FET device which is connected between the power supply source and the control node;
the first and second compensation circuit means being operable to stabilise the control voltage such that the current in the load FET or FETs remains constant notwithstanding variations in the power supply means and channel widths and lengths and the threshold voltages.

How the invention can be carried out will now be described by way of example, with reference to Figs. 2 to 5 of the accompanying drawings, in which:
Fig. 2 shows variations in circuit delay and P-channel current versus process parameters and power supply tolerances;
Fig. 3 shows a VLSI ship including a bias voltage generator embodying the present invention;
Fig. 4 shows a circuit schematic of an on-chip bias voltage generator embodying the present invention; and
Fig. 5 shows a graph of the output voltage of the bias voltage generator as the current in the load device varies between -3 sigma and +3 sigma.

Fig. 2 shows a graph of P-channel load current and circuit delay for load device Q26 connected with its gate electrode connected to ground, as shown in the known inverter circuit arrangement of Fig. 1. The graph is helpful in understanding the power/performance problems which can be overcome by application of the present invention. As is shown in Fig. 2, the statistical distribution or spread from worst case (-3 sigma limit) to best case (+3 sigma limit) is plotted on the horizontal axis while the normalised circuit delay or P-channel current ratio is plotted on the vertical axis. The variation is caused by tolerances in the power supply voltage (Vps) and variation due to process and/or device parameters. The curve which represents P-channel current has a positive slope while the curve which represents circuit delay has a negative slope. A casual review of the graph shows that as the device performance varies between -3 sigma and +3 sigma the circuit performance varies by a ratio of 4.

The invention is concerned with a bias voltage generator to generate a bias voltage for application to the gate or control electrode of the load device Q26 (Fig. 1) The bias voltage generator compensates for variation due to process parameters and power supply tolerances which reduces the current variation in the load device from 400% to 40%.

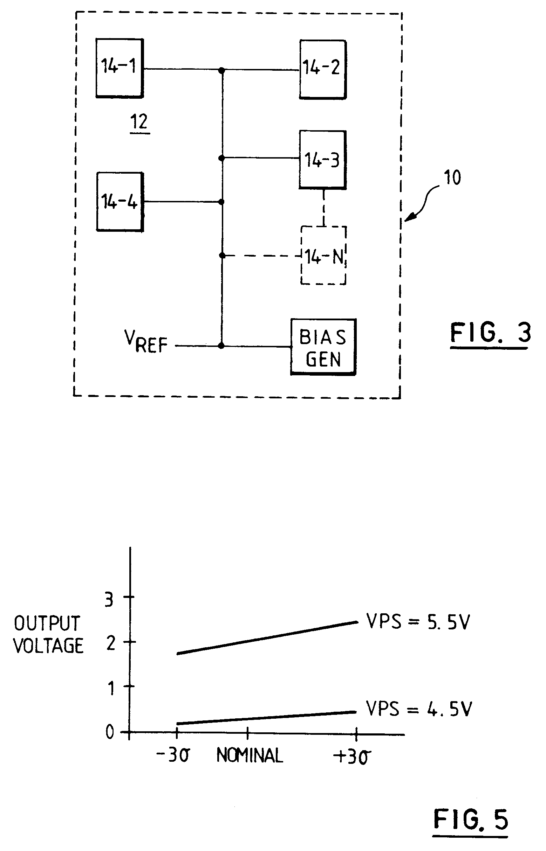

Fig. 3 shows a VLSI chip 10 incorporating the present invention. The chip is exploded or magnified beyond its normal size for purposes of explanation. In actuality, the surface area of the chip is within millimeter range. Still referring to Fig. 3, the chip comprises a substrate 12 upon which a plurality of circuit arrangements are integrated. For brevity, only those circuit arrangements which are germane to explaining the present invention are shown, it being understood that the chip is populated with other circuit arrangements which are not shown in the sketch of Fig. 3. A plurality of static CMOS circuit arrangements 14-1 through 14-N are integrated on substrate 12. The static CMOS circuits may include PLAs, dotted circuits connected as bus structures, inverter circuits, etc. Each of these circuit arrangements includes a pull-up device which is biased by a bias voltage generator embodying the invention in order to minimize power dissipation in those circuit arrangements.

Thus, the present invention provides an on-chip bias generator which outputs a voltage Vreference (Vref) which is connected to the pullup devices (not shown) of each of the static CMOS circuits. For example, if each of the static CMOS circuits 14-1 through 14-N includes an inverter circuit such as the prior art inverter circuit of Fig. 1, the output Vreference from bias generator is connected to the gate electrode of the P-channel enhancement mode device Q26. With this configuration the power performance spread of the P-channel device is brought within acceptable range. Of course, a bias voltage generator embodying the present invention may be used to bias other types of static CMOS circuits.

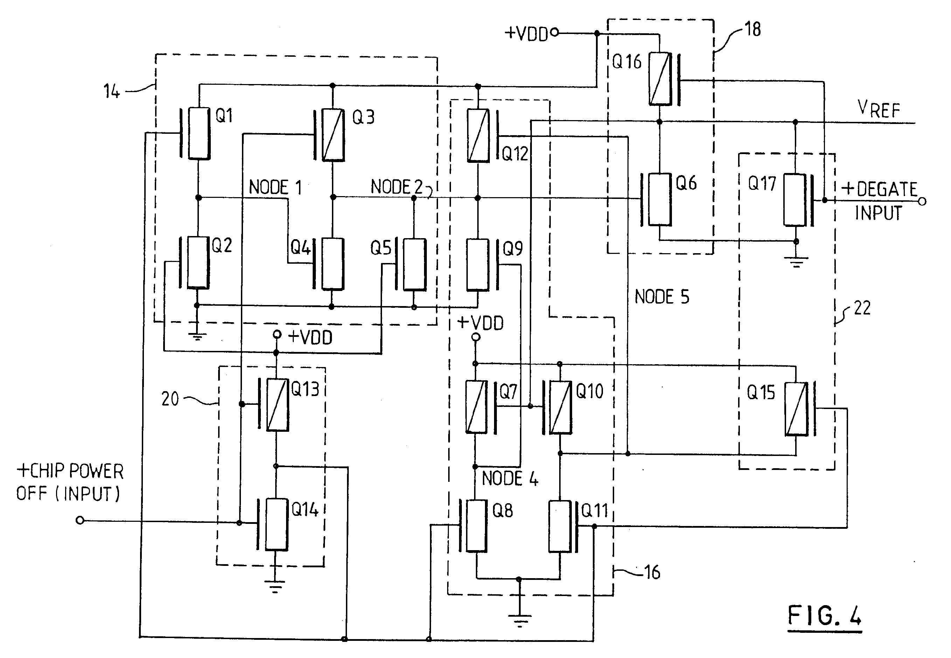

Fig. 4 shows a circuit diagram of the voltage bias generator including a plurality of compensating circuits which are coupled through an output circuit to provide an output voltage which is applied to the gate electrodes of P-channel load devices. The bias voltage compensates for variations due to the process parameters of device channel length, channel width, and threshold voltage. The voltage is also adjusted for variation in the power supply voltage (VDD).

Generally, compensation is achieved by the technique of ratioing nominal parameters of two FET devices which are connected in series. A plurality of the series connected devices are arranged in parallel to provide a nominal value for a desired output voltage. The bias voltage generator includes a first compensation circuit arrangement 14, and a second compensation circuit arrangement 16. The first compensation circuit arrangement 14 compensates for tolerance in the power supply (VDD) and variation in the device parameters due to process variation. The second compensation circuit arrangement 16 adjusts for variation in device threshold voltage (Vt). The first and second compensation circuit arrangements 14 and 16 are connected to node 1. Node 2 in turn is connected by an output circuit arrangement 18 which produces the reference voltage, Vref.

In the preferred embodiment of this invention, the output circuit arrangement 18 is an inverter circuit formed by devices Q6 and Q16. It should be noted that devices with a diagonal such as Q16 and similar ones are P-channel enhancement mode devices while devices with no diagonals such as Q6 and similar ones are N_channel enhancement mode devices. Circuit arrangements 20 and 22 provide testability to the voltage generator.

Still referring to Fig. 4, the first compensation circuit means 14 includes N-channel FET devices Q1 and Q2 which are connected in series between VDD and ground potential and a P-channel FET device Q3 which is also connected to VDD. The first compensation circuit 14 further includes a pair of N-channel FET devices Q4 and Q5 which are positioned in parallel and connected to the drain electrode of Q3. The combination of Q3 in a series with the parallel arrangement of Q4 and Q5 is connected between VDD and ground. Node 1 which is positioned between devices Q1 and Q2 is connected to the gate electrode of Q4. In operation, devices Q1-Q5 bias node 2 such that a desired bias voltage is achieved for most combinations of voltages and parameters. The voltage at node 1 is designed to be about VDD/2. As the power supply voltage is raised from 4.5 volts to 5.5 volts, the (Vgs-Vt) of Q4 increases by approximately 40%. For devices Q3 and Q5 their Vgs-Vt increases by approximately 30% as VDD increases from 4.5 to 5.5 volts. To obtain the desired output voltage, the voltage at node 2 must increase only 0.100 volt while VDD is raised from 4.5 to 5.5 volts. The operation of devices Q3, 4 and 5 are designed to be in anti-phase. As VDD increases, the current in Q3 increases and tends to pull the voltage at node 2 high. However, the gate voltage of devices Q4 and Q5 increase with increasing VDD thereby tending to pull the voltage at node 2 low. The reverse effects apply for decreasing VDD. By choosing the appropriate device sizes for Q3, 4 and 5 a desired change of 0.1 volts at node 2 can be achieved.

To compensate for variations in device parameters, the FETs are designed in large and small widths and channel lengths. For best case parameters (highest device current) the output voltage must be higher. Therefore, the voltage at node 2 must decrease for best case (+3 sigma) parameters. The width and length of the device are a nominal value +/- the tolerance.$\text{DW = W nominal + tolerance}$$\text{DL = L nominal + tolerance}$
where D represents Device
W represents Width
L represents Length

For a device with a large W nominal and L nominal, the current will be insensitive to parameter variations (tolerance). The current in devices with small W nominal and L nominal will increase significantly for best case parameters (+3 sigma) versus worst case parameters (-3 sigma).
Device Q3 (Fig. 4) has large geometries and devices Q4 and Q5 have small geometries so that the voltage at node 2 will decrease as parameters vary from -3 sigma to +3 sigma. For example, the following set of parameters are suitable values for devices Q3, Q4, Q5.

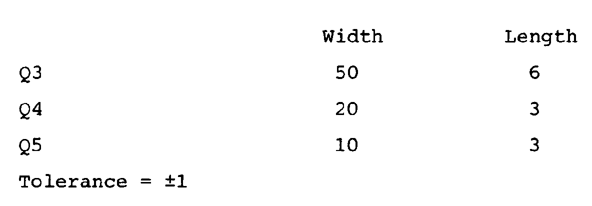

Hence, it can be seen that the width to length ratio (W/L) of device Q3 only varies 20% from nominal to +3σ while the W/L ration of Q5 varies by 65% from nominal to +3σ.

Still referring to Fig. 4, the second compensation circuit arrangement includes devices Q7 through Q12. Each of a parallel pair of P-channel FET devices Q7 and Q10 is connected in series with an individual one of N-channel devices Q8 and Q11. Devices Q7 and Q8 are connected at node 4 which in turn is connected to the gate electrode of device Q9. The source electrode of device Q9 is connected to node 2 and the drain electrode is connected to ground potential. Similarly, devices Q10 and Q11 are connected in series at node 5 which is connected to the gate electrode of device Q12. Device Q12 is connected to node 2 and VDD. In operation, devices Q7-Q12 compensate for variations in device threshold voltage (Vt). When the P-channel threshold voltage, Vt, is low, resulting in an increased (Vgs-Vt), the current in the load device (such as Q26), Fig. 1, will be too high. Current in device Q7 (Fig. 4) will increase and the voltage at node 4 will rise turning on device Q9. Current in device Q9 reduces the voltage at node 2 which reduces the current capability of Q6. The bias voltage rises slightly reducing the current in the load device and in Q7. When the threshold voltage, Vt, of the P-channel device is high, resulting in a decreased (Vgs-Vt), the current in the load devices is too low.

The bias voltage generator can be deactivated by devices Q13-Q15 and Q17. P-channel device Q13 is connected in series with N-channel device Q14 between VDD and ground potential. When the +chip power is activated, that is high, devices Q1 and Q3 are turned off so that the voltage at node 2 falls to ground which in turn causes Q6 to also turn off and the bias reference voltage, Vref, to increase to VDD thereby causing the current in all load P-channel devices gated to Vref to be nil. Similarly, devices Q17 and Q15 deactivate the output of the voltage generator when a signal is applied to the Degate input allowing maximum dc power dissipation. The features associated with devices Q13-Q15, Q17 are auxiliary to the bias generator function and provide the additional function of auto-override, both for minimum and maximum power checking and testability.

## Claims

1. A bias voltage generator for static circuits on a CMOS chip comprising a first and a second compensation circuit producing a bias reference voltage coupled to at least one load FET to maintain a constant current within the FET or FETs characterised by:
the first compensation circuit comprising a first and second FET device of a first conductivity type (Q1,Q2) which are connected in series between a power supply source and a reference potential and a first FET device of opposite conductivity type (Q3) which is also connected to the power supply source in series with a pair of first conductivity FET devices (Q4,Q5) which are positioned in parallel with one another and are connected to the drain of said first opposite conductivity type FET device (Q3), said first compensation circuit serving to bias a control node at a control voltage whose value is governed by the power supply means and the channel width, length and threshold voltages of the devices;
the control node being coupled to an output means thereby producing a variable bias reference voltage (Vref) on the gate of said one or more load FETs; and
the second compensation circuit being coupled to the control node and operable to maintain the constant current within the load FET or FETs, via a bias voltage feedback means and comprising a pair of opposite conductivity type FET devices (Q7,Q10) each connected in series with individual first conductivity type FET devices (Q8,Q11) and connected to a further first conductivity type FET device (Q9) which is connected between the control node and the reference potential and to a first conductivity type FET device (Q12) which is connected between the power supply source and the control node;
the first and second compensation circuit means being operable to stabilise the control voltage such that the current in the load FET or FETs remains constant notwithstanding variations in the power supply means and channel widths and lengths and the threshold voltages.

2. A bias voltage generator as claimed in claim 1, wherein the first compensation circuit arrangement includes a first circuit means (Q1, Q2) for generating a first voltage, and
a second circuit means (Q3, Q4, Q5) responsive to the first voltage to generate the control voltage at the control node.

3. A bias voltage generator as claimed in claim 1 or claim 2, wherein the first circuit means includes a pair of N-channel FET devices (Q1, Q2) connected in series.

4. A bias voltage generator as claimed in claim 2 or claim 3, wherein the second circuit means includes a P-channel FET device (Q3) coupled to a supply voltage source (+VDD), and a pair of N-channel FET devices (Q4, Q5) coupled in parallel relative to one another and each coupled in series relative to the P-channel device.

5. A bias voltage generator as claimed in any preceding claim, wherein the second compensation circuit arrangement includes two pairs of series-connected FET devices (Q7, Q8; Q10, Q11) positioned in a parallel configuration between a voltage supply source (+VDD) and a ground potential; and two switching FET devices (Q9, Q12) connected in series with each switching device having its control electrode connected to an individual one of the nodes between the devices in each pair of series-connected FET devices.

## Revendications

1. Vorspannungsgenerator für statische Schaltkreise auf einem CMOS-Chip, der einen ersten und einen zweiten Kompensationsschaltkreis aufweist, die eine Vorspannungs-Referenzspannung erzeugen, die an wenigstens einen Last-FET gekoppelt ist, um innerhalb des FET bzw. der FETs einen konstanten Strom beizubehalten, dadurch gekennzeichnet, daß
der erste Kompensationsschaltkreis eine erste und ein zweite FET-Vorrichtung eines ersten Leitfähigkeitstyps (Q1, Q2) aufweist, die in Reihe zwischen einer Stromversorgungsquelle und einem Referenzpotential geschaltet sind, und eine erste FET-Vorrichtung (Q3) des entgegengesetzten Leitfähigkeitstyps, die ebenfalls in Reihe mit einem untereinander parallel geschalteten Paar FET-Vorrichtungen (Q4, Q5) der ersten Leitfähigkeit, und mit dem Drain der FET-Vorrichtung (Q3) der ersten entgegengesetzten Leitfähigkeit an die Stromversorgungsquelle angeschlossen ist, wobei dieser erste Kompensationsschaltkreis dazu dient, einen Steuerknoten mit einer Steuerspannung vorzuspannen, deren Höhe von dem Stromversorgungsmittel und der Kanalbreite, -länge und Schwellenspannungen der Vorrichtung geregelt wird;
wobei der Steuerknoten an ein Ausgangsmittel gekoppelt ist und somit eine veränderbare Vorspannungsreferenzspannung (Vref) auf das Gate dieses einen bzw. mehrerer Last-FETs legt; und
der zweite Kompensationsschaltkreis an den Steuerknoten gekoppelt und betreibbar ist, um den Strom im Last-FET bzw. in den Last-FETs mittels eines Vorspannungs-Rückkopplungsmittels konstant zu halten und ein Paar FET-Vorrichtungen (Q7, Q10) des entgegengesetzten Leitfähigkeitstyps beinhaltet, die jeweils in Reihe mit einzelnen FET-Vorrichtungen (Q8, Q11) des ersten Leitfähigkeitstyps geschaltet sind und an eine weitere FET-Vorrichtung (Q9) des ersten Leitfähigkeitstyps, der zwischen dem Steuerknoten und dem Referenzpotential liegt, und an eine FET-Vorrichtung (Q12) des ersten Leitfähigkeitstyp, die zwischen der Stromversorgungsquelle und dem Steuerknoten liegt, geschaltet sind;
wobei der erste und der zweite Kompensationsschaltkreis betreibbar ist, um den Steuerknoten so zu stabilisieren, daß der Strom im Last-FET bzw. in den Last-FETs konstant bleibt, trotz Veränderungen in der Stromversorgung und in den Kanalbreiten und -längen und in den Schwellenspannungen.

2. Vorspannungsgenerator gemäß Anspruch 1, in dem die erste Kompensationsschaltungsanordnung ein erstes Schaltkreismittel (Q1, Q2) zum Generieren einer ersten Spannung, und
ein zweites Schaltkreismittel (Q3, Q4, Q5), das auf die erste Spannung anspricht, um die Steuerspannung am Steuerknoten zu generieren, beinhaltet.

3. Vorspannungsgenerator gemäß Anspruch 1 oder 2, in dem das erste Schaltkreismittel ein Paar in Reihe geschaltete N-Kanal-FET-Vorrichtungen (Q1, Q2) aufweist.

4. Vorspannungsgenerator gemäß Anspruch 2 oder 3, in dem das zweite Schaltkreismittel eine P-Kanal-FET-Vorrichtung (Q3), gekoppelt an eine Versorgungsspannungsquelle (+VDD) sowie ein Paar zueinander parallel geschalteter N-Kanal-FET-Vorrichtungen (Q4, Q5) aufweist, die jeweils zur P-Kanal-Vorrichtung in Reihe geschaltet sind.

5. Vorspannungsgenerator gemäß einem beliebigen der vorstehenden Ansprüche, in dem die zweite Kompensationsschaltungsanordnung zwei Paar reihengeschalteter FET-Vorrichtungen (Q7, Q8; Q10, Q11) in Parallelkonfiguration zwischen einer Versorgungsspannungsquelle (+VDD) und Massepotential aufweist; und zwei Schalt-FET-Vorrichtungen (Q9, Q12) in Reihe mit den einzelnen Schaltvorrichtungen liegen, wobei ihre Steuerelektrode mit jeweils einem einzelnen der Knoten zwischen den Vorrichtungen in den einzelnen Paaren der reihengeschalteten FET-Vorrichtungen verbunden sind.

## Patentansprüche

1. Générateur de tension de polarisation pour circuits statiques d'une puce CMOS comprenant un premier et un second circuits de compensation produisant une tension de référence de polarisation reliés à au moins un transistor FET de charge pour maintenir un courant constant dans le ou les FET caractérisé en ce que:
le premier circuit de compensation comprend un premier et un second dispositifs FET d'un premier type de conductivité (Q1, Q2) qui sont connectés en série entre une source d'énergie et un potentiel de référence,et un premier dispositif FET de conductivité opposée (Q3) qui est aussi connecté à la sour ce d'énergie en série avec une paire de FET de première conductivité (Q4, Q5) placés en parallèle l'un par rapport à l'autre et qui sont aussi connectés au drain dudit premier FET de type de conductivité opposé (Q3), ledit premier circuit de compensation servant à polariser un noeud de contrôle par une tension de contrôle dont la valeur est commandée par des moyens source d'énergie ainsi que la largeur et la longueur de canal et les tensions seuil desdits dispositifs ;
le noeud de contrôle est relié à un moyen de sortie ce qui produit une tension de référence de polarisation variable (Vref) sur la grille du ou desdits FET de charge ; et
le second circuit de compensation est relié au noeud de contrôle et peut fonctionner de manière à maintenir le courant constant dans le ou les transistors FET de charge via un moyen de réaction de tension de polarisation et comprend une paire de dispositifs FET de type de conductivité opposée (Q7, Q10) chacun étant connecté en séries avec un dispositif FET de premier type de conductivité (Q8, Q11) et connecté à un autre FET de premier type de conductivité (Q9) lequel est connecté entre le noeud de contrôle et la tension de référence ainsi qu'à un dispositif FET de premier type de conductivité (Q12) lequel est connecté entre la source d'alimentation et le noeud de contrôle ;
les premier et second circuits de compensation peuvent fonctionner pour stabiliser la tension de contrôle de facon telle que le courant dans le ou les transistors FET de charge demeure constant quelles que soient les variations de la source d'alimentation ainsi que les largeurs et longueurs de canal et les tensions de seuil.

2. Générateur de tension de polarisation selon la revendication 1, dans lequel le premier circuit de compensation comprend un premier circuit (Q1, Q2) pour engendrer une première tension, et
un second circuit (Q3, Q4, Q5) sensible à la première tension pour engendrer la tension de contrôle du noeud de contrôle.

3. Générateur de tension de polarisation selon la revendication 1 ou 2 dans lequel le premier circuit comprend une paire de dispositifs FET à canal N (Q1, Q2) montés en série.

4. Générateur de tension de polarisation selon la revendication 2 ou 3, dans lequel le second circuit comprend un dispositif FET à canal P (Q3) relié à la source de tension d'alimentation (+VDD), et une paire de transistors FET à canal N (Q4, Q5) montés en parallèle l'un par rapport à l'autre et chacun étant en série avec le dispositif à canal P.

5. Générateur de tension de polarisation selon l'une des revendications précédentes, dans lequel le second circuit de compensation comprend deux paires de transistors FET en série (Q7, Q8 ; Q10, Q11), les paires étant mises en parallèle l'une par rapport à l'autre et l'ensemble étant placé entre une source de tension d'alimentation (+VDD) et la masse ; et deux dispositifs FET de commutation (Q9, Q12) montés en série avec chaque dispositif de commutation ayant son électrode de commande connectée à l'un des noeuds entre les éléments de chacune des paires d'éléments FET connectés en séries.
